# FASCICULE DE BREVET EUROPEEN

(11) **EP 4 206 826 B1**
(45) Date de publication et mention de la délivrance du brevet: **29.04.2026**
(21) Numéro de dépôt: 22161663.4
(22) Date de dépôt: 11.03.2022
(51) Int. Cl.: C25D 7/00, G04B 19/10, C25D 1/00, G04B 19/12, C25D 5/02

(54) **PROCÉDÉ DE FABRICATION D'APPLIQUES SUR UN CADRAN**
VERFAHREN ZUR HERSTELLUNG VON APPLIKEN AUF EINEM ZIFFERBLATT
METHOD FOR MANUFACTURING BRACKETS ON A DIAL

(30) Priorité: 30.12.2021 EP 21218285
(43) Date de publication de la demande: 05.07.2023
(73) Titulaire: Rubattel et Weyermann S.A., 2300 La Chaux-de-Fonds (CH)
(72) Inventeur: POLY, Giovanni, 25130 Villers- Le-Lac (FR); GROBE, Jonas, 2316 Les Ponts-de-Martel (CH); JEANRENAUD, Frédéric, 2300 La Chaux-de-Fonds (CH)
(74) Mandataire: ICB SA

(56) Documents cités:
- EP-A1- 2 182 096
- EP-A1- 3 536 826
- EP-A1- 3 786 722
- JP-A- 2007 101 271
- US-A1- 2014 356 638

## Description

### Objet de l'invention

La présente invention concerne un procédé de fabrication d'appliques sur un cadran pour une pièce d'horlogerie.

### Arrière-plan technologique

La présente invention vise à améliorer les procédés de dépôts de motifs décoratifs à la surface d'un composant d'horlogerie.

Un cadran de pièce d'horlogerie comporte habituellement des appliques permettant de le décorer. Ces appliques peuvent par exemple représenter un tour d'heure destiné à faciliter la détermination de l'heure par rapport à l'emplacement des aiguilles de la pièce d'horlogerie. Ces appliques peuvent également être utilisées pour plus simplement apporter un effet esthétique au cadran.

Habituellement, ces appliques sont montées sur le cadran par des étapes successives de collage puis éventuellement de masquage et/ou de tamponnage ce qui, en plus du prix des appliques, occasionne des surcoûts de fabrication dû à la précision de positionnement exigé qui est d'autant plus grande que l'applique est épaisse. Le document EP 2 182 096 A1 montre un procédé de fabrication de pièces métalliques sur un substrat pour pièce d'horlogerie, comprenant les étapes de :
- fournir un substrat, le substrat présentant une face avant et une face arrière;
- effectuer une préparation de surface de la face avant, puis structurer sélectivement la face avant et y déposer au moins une couche;
- déposer une première couche de protection tout autour du cadran muni de l'au moins une couche;
- usiner au moins un évidement dans la première couche de protection pour former un moule pour les futures appliques;
- remplir d'un matériau ledit au moins un évidement par galvanoplastie à partir du substrat pour former les pièces métalliques;
- retirer la première couche de protection;
- déposer une deuxième couche de protection sur la face avant du substrat pour recouvrir la face avant du substrat et les pièces métalliques;
- polir la deuxième couche de protection et les pièces métalliques sur une hauteur prédéterminée;
- retirer la deuxième couche de protection.

### Résumé de l'invention

La présente invention concerne un procédé de fabrication d'appliques sur un cadran pour pièce d'horlogerie, comprenant les étapes suivantes :
a) fournir un cadran, le cadran présentant une face avant et une face arrière ;
b) effectuer une préparation de surface de la face avant ;
c) déposer une première couche de protection tout autour du cadran muni de l'au moins une couche de décoration ;
d) usiner au moins un évidement dans la première couche de protection et la couche de décoration pour former un moule pour les futures appliques, et percer le cadran pour former au moins un point d'accroche ;
e) remplir d'un matériau ledit au moins un évidement par galvanoplastie à partir du cadran pour former les appliques ;
f) retirer la première couche de protection ;
g) déposer une deuxième couche de protection sur la face avant du cadran pour recouvrir le cadran et les appliques ;
h) découper le cadran aux dimensions souhaitées et polir la deuxième couche de protection et les appliques sur une hauteur prédéterminée ;
i) effectuer un traitement de surface sélectif sur le sommet des appliques ;
j) retirer la deuxième couche de protection.

Conformément à d'autres variantes avantageuses de l'invention :
- le cadran est réalisé dans un matériau choisi parmi les alliages de cuivre, les alliages de fer, les alliages d'or ou les alliages d'argent ;
- la couche de décoration est réalisée dans un matériau choisi parmi l'argent, l'or, le cuivre, le nickel, le rhodium ou le ruthénium ;
- la première couche de protection et la deuxième couche de protection sont réalisées à base d'une résine ;
- la résine est choisie parmi les résines acrylique, les résines nitro-cellulosiques, les résines alkydes ou les résines polyuréthanes ;
- ledit matériau remplissant l'au moins un évidement est choisi parmi l'argent, l'or, le cuivre, le nickel, le rhodium ou le ruthénium ;
- les première et deuxième couches de protection sont retirées au moyen d'un solvant ou par plasma ;
- la gravure de l'au moins un évidement est effectuée par un procédé de gravure laser permettant de graver la couche de décoration
et la première couche de protection ;
- lors de l'étape b), la préparation de surface de la face consiste à polir, poncer et/ou sabler en milieu sec ou humide la face avant du cadran.
- lors de l'étape b), le traitement de surface de la face avant est une opération de microbillage, de soleillage, de guillochage, de gravure, de fraisage, de colimaçonnage, de cerclage, de perlage ou tout autre opération permettant d'obtenir une structure décorative.

### Brève description des figures

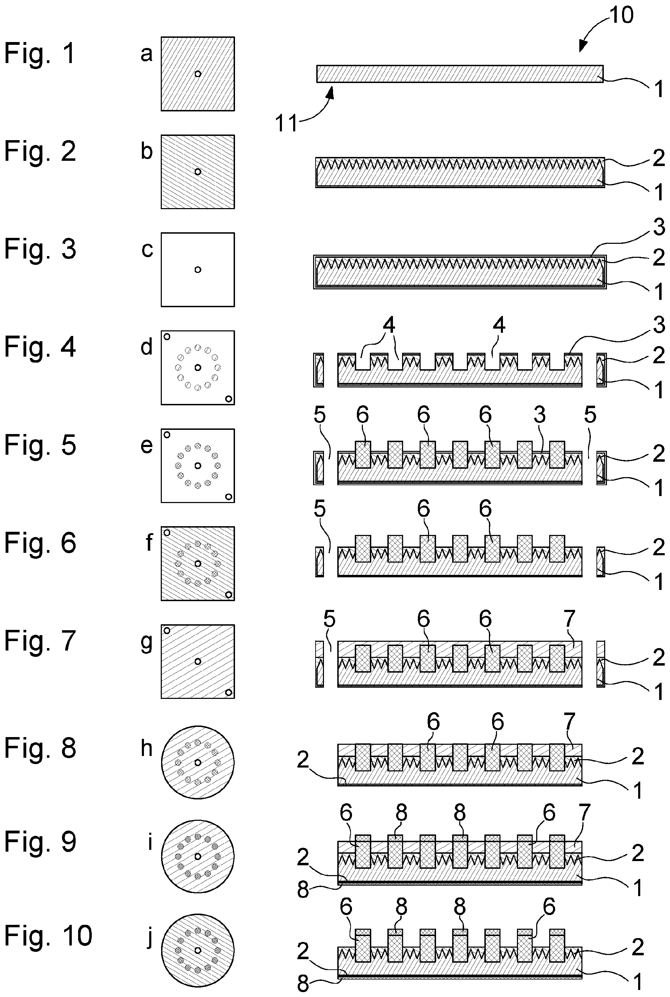

- Les figures 1 à 10 représentent les étapes successives d'un exemple préféré de procédé de décoration selon l'invention.

### Description détaillée de l'invention

Le procédé selon l'invention sera mieux compris en relation avec les figures 1 à 10. Dans une première étape a) illustrée à la figure 1, le procédé selon l'invention consiste à fournir un cadran 1 comprenant une face avant 10 et une face arrière 11, la face avant étant destinée à recevoir les appliques.

Préférentiellement selon l'invention, le cadran est formé dans un matériau choisi parmi les alliages de cuivre, les alliages de fer, les alliages d'or ou les alliages d'argent.

Bien entendu, alternativement à l'utilisation d'un cadran en matériau électriquement conducteur, il est également possible d'utiliser un cadran en un matériau quelconque revêtu d'une couche électriquement conductrice. On pourra par exemple imaginer un cadran en céramique revêtu d'une couche en argent.

Comme illustré à la figure 2, la deuxième étape b) du procédé consiste à effectuer une préparation de surface de la face avant 10 dans un premier temps, puis structurer sélectivement la face avant 10 afin d'y modifier localement l'état de surface et enfin y déposer au moins une couche de décoration 2 sur l'intégralité du cadran.

La préparation de surface de la face avant 10 consiste à polir, poncer et/ou sabler en milieu sec ou humide la face avant du cadran. Un traitement par plasma ou laser est également envisageable.

La structuration de la face avant du cadran consiste en une opération classique de décoration horlogère. Ainsi la structuration est une opération choisie par le microbillage, le soleillage, le guillochage, la gravure, le fraisage, le colimaçonnage, le cerclage, le perlage ou tout autre opération donnant une structure décorative ou tout autre opération permettant d'obtenir une structure décorative. Cette étape est destinée à la fois à décorer le cadran et à augmenter l'adhérence de la surface du cadran pour le dépôt de la couche de décoration.

La couche de décoration 2 est réalisée dans un matériau choisi parmi l'argent, l'or, le cuivre, le nickel, le rhodium, le ruthénium ou tout autres revêtements possibles pouvant être obtenus par voie humide (dépôt chimique ou électrolytique) ou par voie sèche (pulvérisation, PVD).

Optionnellement, pour améliorer la stabilité mécanique de l'interface entre la couche de décoration 2 et le cadran 1, une couche intermédiaire adhésive peut avantageusement être déposée entre la couche de décoration 2 et le cadran 1. Par exemple, le titane présente généralement une adhésion adéquate sur la plupart des substrats usuels. L'épaisseur de cette couche peut être extrêmement faible : quelques nm suffisent généralement à améliorer considérablement l'adhésion.

La couche métallique déposé sur la surface du cadran possède de bonnes propriétés adhésives pour favoriser l'adhésion des appliques formées. Le matériau de la couche peut être du titane, du nickel, de l'or ou un autre matériaux et/ou combinaison de plusieurs couches.

Préférentiellement, la couche de décoration est réalisée par dépôt physique en phase vapeur (PVD), cependant, d'autres types de dépôt sont envisageables comme la galvanoplastie, le dépôt chimique en phase vapeur (CVD) ou le dépôt par couche atomique (ALD).

Comme illustré à la figure 3, la troisième étape c) du procédé consiste à recouvrir entièrement le cadran d'une couche polymère 3 par pulvérisation, immersion ou à la tournette (également connu sous les termes anglais « spin coating »), puis à faire polymériser la résine 3 via de la chaleur ou des rayons UV. Bien évidemment, l'épaisseur de la couche dépendra de la taille désirée des appliques, de préférence l'épaisseur de la couche est comprise entre 0.02 mm à 0.40 mm.

La résine 3 est choisie parmi les résines acrylique, les résines nitro-cellulosiques, les résines alkydes ou les résines polyuréthanes.

A titre de variante, il est possible d'entièrement recouvrir de résine 3 le cadran 1, puis de la faire polymériser, et d'usiner le dessus de la couche de résine afin de rendre sa partie supérieure parfaitement plane.

Comme illustré à la figure 4, la quatrième étape d) du procédé consiste à usiner au moins un évidement 4 dans la couche de protection et la couche de décoration pour former un moule pour les futures appliques. Au cours de cette étape le cadran est également percé à plusieurs endroits pour former au moins un point d'accroche 5 lors de la croissance galvanique de l'étape suivante.

Avantageusement, l'au moins un évidement 4 est formé par un procédé laser ou par photolithographie à l'aide d'une résine positive ou négative, afin de contrôler aisément la géométrie de la future applique, de faire des évidements 4 ayant des parois essentiellement perpendiculaires à la surface du cadran 1, de graver rapidement de nombreuses pièces, et enfin, de contrôler de façon fine l'état de surface de la zone gravée.

Comme illustré à la figure 5, la cinquième étape e) du procédé consiste à déposer un matériau par galvanoplastie à partir de la face avant 10 du cadran 1 électriquement conducteur afin de former en une seule étape au moins une applique 6. Le cadran 1 est plongé dans un bain galvanique par le biais de l'au moins un point d'accroche 5 qui permet également d'utiliser le cadran 1 comme cathode.

Le matériau utilisé pour remplir l'au moins un évidement 4 et former l'applique 6 sur le cadran 1 est choisi parmi l'argent, l'or, le cuivre, le nickel, le rhodium ou le ruthénium.

Le matériau utilisé pour former l'applique 6 peut être différent de celui utilisé pour la couche de décoration en fonction du résultat esthétique recherché.

Comme illustré à la figure 6, la sixième étape f) du procédé consiste à libérer le cadran 1 de la première couche de résine 3 via une dissolution, un décapage ou par plasma. De préférence, un solvant organique adapté à la résine déposée est utilisé pour retirer la première couche de protection.

Comme illustré à la figure 7, la septième étape g) du procédé consiste à recouvrir la face avant 10 du cadran 1 d'une deuxième couche de protection en résine 7 par pulvérisation, puis à faire polymériser la résine 7 via de la chaleur ou des rayons UV. L'épaisseur de cette deuxième couche de résine est au moins équivalente à la hauteur des appliques 6 formées au cours de l'étape e), et de préférence supérieure à la hauteur des appliques 6.

La résine 7 formant la deuxième couche de protection est choisie parmi les résines acrylique, les résines nitro-cellulosiques, les résines alkydes ou les résines polyuréthanes.

Comme illustré à la figure 8 la huitième étape h) du procédé consiste dans un premier temps à usiner le cadran 1 aux dimensions et à la forme souhaitée, puis polir la couche de protection en résine 7 et les appliques 6 sur une hauteur prédéterminée.

Comme illustré à la figure 9, la neuvième étape i) du procédé consiste à effectuer un traitement de surface sélectif sur le sommet des appliques 6.

Le traitement de surface sélectif consiste en un dépôt d'une couche métallique 8 réalisée par dépôt physique en phase vapeur (PVD), dépôt chimique en phase vapeur (CVD), dépôt par couche atomique (ALD) ou par voie humide (traitement galvanique).

Comme illustré à la figure 10, la dixième et dernière étape j) du procédé consiste à supprimer la deuxième couche de protection et de libérer le cadran 1 muni de ses appliques 6.

Des pieds peuvent êtres soudés aux cadrans à différentes étapes de la gamme afin de faciliter la manipulation des pièces et/ou répondre au cahier des charges du produit. Ces pieds peuvent servir de point de contact pour réaliser les revêtements 2 ou former par électroformage les appliques 6. Dans ce dernier cas, ces pieds sont utilisés à la place des perçages 5.

On comprend donc que le procédé, avantageusement selon l'invention, permet l'utilisation des avantages de l'usinage, de la photolithographie et de la galvanoplastie pour électroformer en une seule étape de galvanoplastie les appliques sur un cadran avec une très bonne précision structurelle.

Bien entendu, la présente invention ne se limite pas à l'exemple illustré mais est susceptible de diverses variantes et modifications qui apparaîtront à l'homme de l'art.

De plus, les modes préférés ou variantes du procédé selon l'invention sont uniquement utilisés pour donner un exemple de réalisation de l'invention sans s'y limiter. Ainsi, d'autres matériaux ou d'autres procédés d'enlèvement de matière ou de structuration peuvent être envisagés.

## Revendications

1. Procédé de fabrication d'appliques (6) sur un cadran (1) pour pièce d'horlogerie, le procédé comprenant les étapes suivantes :
a) fournir un cadran (1), le cadran présentant une face avant (10) et une face arrière (11) ;
b) effectuer une préparation de surface de la face avant (10), puis structurer sélectivement la face avant et y déposer au moins une couche de décoration (2) ;
c) déposer une première couche de protection (3) tout autour du cadran muni de l'au moins une couche de décoration ;
d) usiner au moins un évidement (4) dans la première couche de protection (3) et la couche de décoration (2) pour former un moule pour les futures appliques, et percer le cadran (1) pour former au moins un point d'accroche (5) ;
e) remplir d'un matériau ledit au moins un évidement (4) par galvanoplastie à partir du cadran (1) pour former les appliques (6) ;
f) retirer la première couche de protection (3) ;
g) déposer une deuxième couche de protection (7) sur la face avant (10) du cadran (1) pour recouvrir la face avant du cadran et les appliques (6) ;
h) découper le cadran (1) aux dimensions souhaitées et polir la deuxième couche de protection (7) et les appliques (6) sur une hauteur prédéterminée ;
i) effectuer un traitement de surface sélectif sur le sommet des appliques (6) ;
j) retirer la deuxième couche de protection (7).

2. Procédé selon la revendication 1, dans lequel le cadran (1) est réalisé dans un matériau choisi parmi les alliages de cuivre, les alliages de fer, les alliages d'or ou les alliages d'argent.

3. Procédé selon la revendication 1 ou 2, dans lequel la couche de décoration (2) est réalisée dans un matériau choisi parmi l'argent, l'or, le cuivre, le nickel, le rhodium ou le ruthénium.

4. Procédé selon l'une des revendications précédentes, dans lequel la première couche de protection et la deuxième couche de protection sont réalisées à base d'une résine.

5. Procédé selon la revendication 4, dans lequel la résine est choisie parmi les résines acrylique, les résines nitro-cellulosiques, les résines alkydes ou les résines polyuréthanes.

6. Procédé selon l'une des revendications 1 à 5, dans lequel ledit matériau remplissant l'au moins un évidement est choisi parmi l'argent, l'or, le cuivre, le nickel, le rhodium ou le ruthénium.

7. Procédé selon l'une de revendications précédentes, dans lequel la couche de décoration (2) comprend une couche adhésive comprenant de préférence du titane.

8. Procédé selon l'une des revendications 1 à 7, dans lequel les première et deuxième couches de protection sont retirées au moyen d'un solvant.

9. Procédé selon l'une des revendications précédentes, dans lequel la gravure de l'au moins un évidement (4) est effectuée par un procédé de gravure laser permettant de graver la couche de décoration (2) et la première couche de protection (3).

10. Procédé selon l'une quelconque des revendications précédentes, dans lequel lors de l'étape b), la préparation de surface de la face consistant à polir, poncer et/ou sabler la face avant du cadran

11. Procédé selon l'une quelconque des revendications précédentes, dans lequel lors de l'étape b), le traitement de surface de la face avant est une opération de microbillage, de soleillage, de guillochage, de gravure, de fraisage, de colimaçonnage, de cerclage ou de perlage.

## Patentansprüche

1. Verfahren für eine Herstellung von Appliken (6) auf einem Zifferblatt (1) für einen Zeitmesser, **dadurch gekennzeichnet, dass** es die folgenden Schritte aufweist:
a) Bereitstellen eines Zifferblatts (1), wobei das Zifferblatt eine Vorderseite (10) und eine Rückseite (11) aufweist;
b) Ausführen einer Oberflächenpräparationsbehandlung an der Vorderseite (10), dann selektives Strukturieren der Vorderseite und Aufbringen mindestens einer dekorativen Schicht (2) darauf;
c) Aufbringen einer ersten Schutzschicht (3) rund um das Zifferblatt, das mit der mindestens einen dekorativen Schicht versehen ist;
d) Bearbeiten mindestens einer Vertiefung (4) in der ersten Schutzschicht (3) und der dekorativen Schicht (2), um eine Form für zukünftige Appliken zu bilden, und Bohren des Zifferblatts (1), um mindestens einen Haftpunkt (5) zu bilden;
e) Füllen der mindestens einen Vertiefung (4) mit einem Material durch Elektroplattieren auf dem Zifferblatt (1), um die Appliken (6) zu bilden;
f) Entfernen der ersten Schutzschicht (3);
g) Aufbringen einer zweiten Schutzschicht (7) auf der Vorderseite (10) des Zifferblatts (1), um die Vorderseite des Zifferblatts und die Appliken (6) zu bedecken;
h) Zuschneiden des Zifferblatts (1) auf die gewünschten Maße und Polieren der zweiten Schutzschicht (7) und der Appliken (6) über eine vorbestimmte Höhe;
i) Ausführen einer selektiven Oberflächenbehandlung an der Spitze der Appliken (6);
j) Entfernen der zweiten Schutzschicht (7).

2. Verfahren nach Anspruch 1, wobei das Zifferblatt (1) aus einem Material, ausgewählt aus Kupferlegierungen, Eisenlegierungen, Goldlegierungen oder Silberlegierungen, hergestellt ist.

3. Verfahren nach Anspruch 1 oder 2, wobei die dekorative Schicht (2) aus einem Material, ausgewählt aus Silber, Gold, Kupfer, Nickel, Rhodium oder Ruthenium, hergestellt ist.

4. Verfahren nach einem der vorhergehenden Ansprüche, wobei die erste Schutzschicht und die zweite Schutzschicht harzbasiert sind.

5. Verfahren nach Anspruch 4, wobei das Harz ausgewählt ist aus Acrylharzen, Nitrocelluloseharzen, Alkydharzen oder Polyurethanharzen.

6. Verfahren nach einem der Ansprüche 1 bis 5, wobei das Material, das die mindestens eine Vertiefung ausfüllt, ausgewählt ist aus Silber, Gold, Kupfer, Nickel, Rhodium oder Ruthenium.

7. Verfahren nach einem der vorhergehenden Ansprüche, wobei die dekorative Schicht (2) eine vorzugsweise Titan enthaltende Klebeschicht aufweist.

8. Verfahren nach einem der Ansprüche 1 bis 7, wobei die erste und zweite Schutzschicht mittels eines Lösungsmittels entfernt werden.

9. Verfahren nach einem der vorhergehenden Ansprüche, wobei das Ätzen der mindestens einer Vertiefung (4) durch ein Laserätzverfahren durchgeführt wird, das ein Ätzen der dekorativen Schicht (2) und der ersten Schutzschicht (3) ermöglicht.

10. Verfahren nach einem der vorhergehenden Ansprüche, wobei in Schritt b) die Oberflächenpräparation der Vorderseite ein Polieren, Schleifen und/oder Sandstrahlen der Vorderseite des Zifferblatts umfasst.

11. Verfahren nach einem der vorhergehenden Ansprüche, wobei in Schritt b) die Oberflächenbehandlung der Vorderseite ein Kugelstrahlen, Sonnenschliff, Guillochieren, Ätzen, Fräsen, Schneckenschliff oder Perliervorgang ist.

## Claims

1. Method for manufacturing appliques (6) on a dial (1) for a timepiece, **characterised in that** it comprises the following steps of:
a) providing a dial (1), the dial having a front face (10) and a rear face (11);
b) carrying out a surface preparation treatment on the front face (10), then selectively structuring the front face and depositing thereon at least one decorative layer (2);
c) depositing a first protective layer (3) all around the dial provided with the at least one decorative layer;
d) machining at least one recess (4) in the first protective layer (3) and the decorative layer (2) to form a mould for future appliques, and boring the dial (1) to form at least one adhesion point (5);
e) filling said at least one recess (4) with a material by electroplating on the dial (1) to form the appliques (6);
f) removing the first protective layer (3);
g) depositing a second protective layer (7) on the front face (10) of the dial (1) to cover the front face of the dial and the appliques (6);
h) cutting the dial (1) to the desired dimensions and polishing the second protective layer (7) and the appliques (6) over a predetermined height;
i) carrying out a selective surface treatment on the tip of the appliques (6);
j) removing the second protective layer (7).

2. Method according to claim 1, wherein the dial (1) is made of a material selected from copper alloys, iron alloys, gold alloys or silver alloys.

3. Method according to claim 1 or 2, wherein the decorative layer (2) is made of a material selected from silver, gold, copper, nickel, rhodium or ruthenium.

4. Method according to one of the preceding claims, wherein the first protective layer and the second protective layer are resin-based.

5. Method according to claim 4, wherein the resin is selected from acrylic resins, nitro-cellulosic resins, alkyd resins or polyurethane resins.

6. Method according to one of claims 1 to 5, wherein said material filling the at least one recess is selected from silver, gold, copper, nickel, rhodium or ruthenium.

7. Method according to one of the preceding claims, wherein the decorative layer (2) comprises an adhesive layer preferably comprising titanium.

8. Method according to one of claims 1 to 7, wherein the first and second protective layers are removed by means of a solvent.

9. Method according to one of the preceding claims, wherein the etching of the at least one recess (4) is carried out by a laser etching method allowing the decorative layer (2) and the first protective layer (3) to be etched.

10. Method according to any one of the preceding claims, wherein in step b), the surface preparation of the face consists of polishing, pumicing and/or sanding the front face of the dial.

11. Method according to any one of the preceding claims, wherein in step b), the surface treatment of the front face is a shot-blasting, sunbursting, engine-turning, etching, milling, snailing, or circular graining operation.
